# FASCICULE DE BREVET EUROPEEN

(11) **EP 0 335 771 B1**
(45) Date de publication et mention de la délivrance du brevet: **03.02.1993**
(21) Numéro de dépôt: 89400782.2
(22) Date de dépôt: 21.03.1989
(51) Int. Cl.: G01R 33/20

(54) **Antenne pour dispositif d'imagerie par résonance magnétique nucléaire**
Antenne für ein Bilderzeugungsgerät mittels magnetischer Kernresonanz
Antenna for a nuclear magnetic resonance imaging apparatus

(30) Priorité: 30.03.1988 FR 8804163
(43) Date de publication de la demande: 04.10.1989
(73) Titulaire: SOPHA IMAGING, F-75018 Paris (FR)
(72) Inventeur: Darrasse, Luc, F-75015 Paris (FR); Ernst, Olivier, F-59170 Croix (FR)
(74) Mandataire: Kremer, Robert A.M.

(56) Documents cités:
- EP-A- 0 171 741
- EP-A- 0 223 284
- EP-A- 0 232 189
- WO-A-84/00214

## Description

La présente invention concerne les dispositifs d'imagerie par résonance magnétique nucléaire comme ceux qui sont utilisés dans les établissements médicaux pour réaliser des images de certaines parties internes du corps humain, notamment le cerveau, plus particulièrement l'examen de l'encéphale et de la charnière bulbo-médullaire en vue, par exemple, de déceler d'éventuelles tumeurs.

Ces dispositifs sont déjà bien connus et relativement couramment utilisés malgré leur coût élevé. Très schématiquement, un tel dispositif comprend, sur un bâti, un aimant comprenant un générateur de champ magnétique dont les forces sont toutes orientées suivant la même direction. Ce générateur est généralement constitué par une pluralité de spires enroulées les unes à côté des autres pour former une bobine magnétique définissant en son centre un espace libre dans lequel se développe les lignes de force d'un champ magnétique homogène dit "principal".

Le dispositif comporte en plus, en association avec l'aimant, un support du corps d'un patient, par exemple un lit monté sur des moyens permettant de déplacer ce lit suivant une direction parallèle à celle des lignes de force du champ magnétique donné par la bobine et au centre de celle-ci.

A ce générateur de champ magnétique statique longitudinal sont associés des moyens pour créer d'autres champs magnétiques ayant des gradients et pouvant être orientés suivant, par exemple, trois directions dans l'espace occupé par le volume de la partie du corps à examiner et dont il est nécessaire de former l'image, par exemple le cerveau dans l'exemple donné ci-avant, des moyens d'excitation à une fréquence radio, et des moyens de détection des signaux de résonance magnétique nucléaire produits par certains des atomes de la partie du corps analysée.

Il est d'ailleurs à préciser que, dans certains dispositifs, les moyens d'excitation et de détection peuvent être constitués par une même partie de capteur, seuls les moyens d'entrée de ce capteur changeant selon la fonction désirée, soit l'excitation, soit la détection. Les techniciens ont l'habitude de dénommer ce type de capteur par le vocable "antenne" (voir, par exemple, EP-A- 232 189).

Ces antennes peuvent prendre différentes structures permettant généralement de définir une zone cylindrique apte à être placée au centre de la bobine magnétique et, de plus, de façon que son axe ait la même direction que le champ magnétique principal défini ci-avant. Cependant, pour pouvoir être pleinement efficace, cette zone cylindrique doit entourer la partie du corps à analyser, et au plus près.

Pour arriver à ce résultat, on a essayé de réaliser des structures de capteur particulières, mais, en fait, aucune d'elles n'a jamais donné une solution attrayante, c'est-à-dire facilitant l'installation du capteur dans le dispositif d'imagerie autour de la partie du corps du patient à analyser, en l'entourant au plus près.

La présente invention a pour but de réaliser un dispositif d'imagerie par résonance magnétique nucléaire, et plus particulièrement son élément "antenne", qui soit d'une structure lui permettant de s'adapter très facilement aux besoins de la réalisation de l'image de la partie de corps à analyser et à cette partie du corps elle-même en l'entourant au plus près, et de créer des champs magnétiques secondaires ayant différentes orientations par rapport au champ magnétique principal engendré par l'aimant.

Plus précisément, la présente invention a pour objet une antenne pour dispositif d'imagerie par résonance magnétique nucléaire, caractérisée par le fait qu'elle comprend :
deux plaques de support en matériau isolant électrique,
des moyens d'entretoise pour maintenir les deux dites plaques à une distance déterminée l'une de l'autre dans deux plans sensiblement parallèles,
des moyens de fixation enclipsables - déclipsables d'au moins une des deux dites plaques avec lesdits moyens d'entretoise,
au moins deux première et deuxième spires en matériau conducteur électrique,
des moyens pour fixer lesdites spires respectivement sur une face des deux dites plaques de façon à former deux boucles de courant centrées sensiblement sur un même axe sensiblement perpendiculaire auxdites faces desdites plaques, et
des moyens de couplage capacitifs des extrémités de chaque boucle de courant.

D'autres caractéristiques et avantages de la présente invention apparaîtront au cours de la description suivante donnée en regard des dessins annexés à titre illustratif, mais nullement limitatif, dans lesquels :
La figure 1 est une vue en perspective définissant de façon schématique les éléments essentiels d'un dispositif d'imagerie par résonance magnétique nucléaire, dans lequel apparaît un mode de réalisation de l'élément "antenne" selon l'invention,
Les figures 2 et 3 représentent respectivement deux coupes perpendiculaires du mode de réalisation d'une antenne pour dispositif d'imagerie par résonance magnétique nucléaire selon l'invention, en accord avec la figure 1, et
Les figures 4 et 5 représentent respectivement deux schémas électriques permettant de mettre en évidence un avantage de la structure d'antenne selon l'invention.

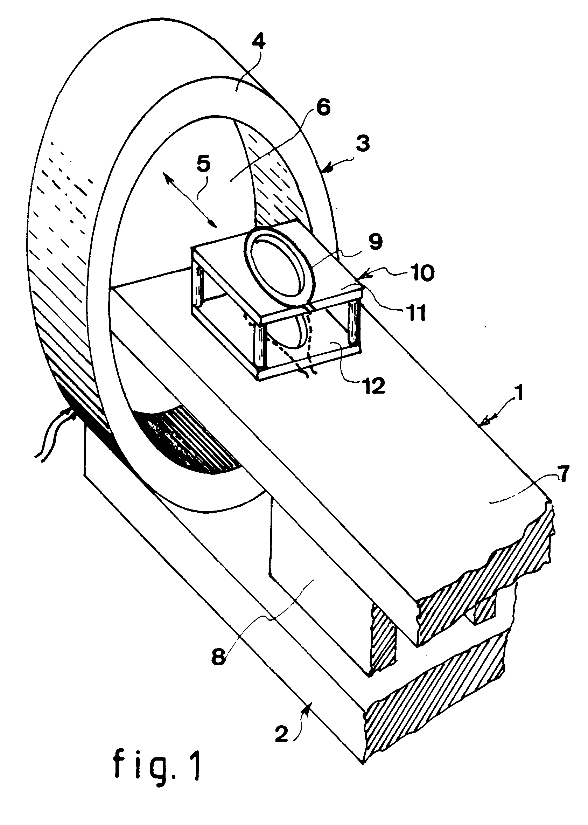

Les figures 1 à 5 représentant le même mode de réalisation d'une antenne pour dispositif d'imagerie par résonance magnétique nucléaire, les mêmes références y désignent les mêmes éléments.

Sur la figure 1 on a représenté, sous forme schématique, un dispositif permettant de réaliser des images de parties du corps humain, couramment dénommé "scaner" par les techniciens.

Un tel dispositif 1 comporte, sur un bâti 2, un aimant 3, le terme "aimant" étant pris dans son sens le plus large, c'est-à-dire représentant aussi bien les aimants permanents que les aimants du type électro-magnétiques. Dans le mode de réalisation choisi, cet aimant 3 comprend un générateur 4 d'un champ magnétique dont les forces sont toutes orientées suivant la même direction 5. Ce générateur 4 est généralement constitué par une pluralité de spires enroulées les unes à côté des autres pour former une bobine magnétique définissant en son centre 6 un espace libre dans lequel se développent les lignes de force du champ magnétique homogène dit "principal".

Le dispositif 1 comporte en plus, en association avec l'aimant 3, un support 7 du corps d'un patient, par exemple un lit monté sur des moyens 8 permettant de le déplacer suivant une direction parallèle à celle 5 des lignes de force du champ magnétique donné par la bobine 4, au centre de l'espace 6 défini par cette bobine, dans son champ magnétique.

A ce générateur de champ magnétique principal longitudinal sont associés des moyens 9 pour créer des champs magnétiques secondaires ayant des gradients et pouvant être orientés suivant, par exemple, trois directions dans l'espace occupé par le volume de la partie du corps à examiner et dont il est nécessaire de former l'image, par exemple le cerveau, des moyens d'excitation à une fréquence radio, et des moyens de détection des signaux de résonance magnétique nucléaire produits par certains des atomes de la partie du corps analysée.

Ces moyens d'excitation et de détection peuvent être constitués par une même partie de capteur, seuls les moyens d'entrée de ce capteur changeant selon la fonction désirée, soit l'excitation, soit la détection. Les techniciens ont l'habitude de dénommer un tel capteur sous le vocable "antenne" 10.

L'antenne 10 permet de définir une zone cylindrique apte à être placée au centre de la bobine magnétique principale 4 et, selon le mode de réalisation illustré, comprend deux plaques de support 11, 12 en un matériau isolant électrique, par exemple en matière plastique.

Ces deux plaques 11, 12 sont maintenues à une distance déterminée l'une de l'autre, et avantageusement dans deux plans sensiblement parallèles, par des moyens d'entretoise 13.

A ces moyens d'entretoise sont associés des moyens de fixation enclipsables - déclipsables 14 avec au moins l'une des deux plaques.

Sur une face 15, 16 des deux plaques sont respectivement situées au moins deux première 17 et deuxième 18 spires en matériau conducteur électrique, et, très avantageusement, deux troisième 19 et quatrième 20 spires sont respectivement fixées sur les deux autres faces 21, 22 des deux plaques 11, 12, opposées respectivement aux faces 15 et 16.

Une telle structure permet de réaliser deux boucles de courant adaptables par lesquelles il est possible d'obtenir un champ magnétique secondaire dont les lignes de force ont une direction perpendiculaire à la direction 5 des lignes de force du champ magnétique principal.

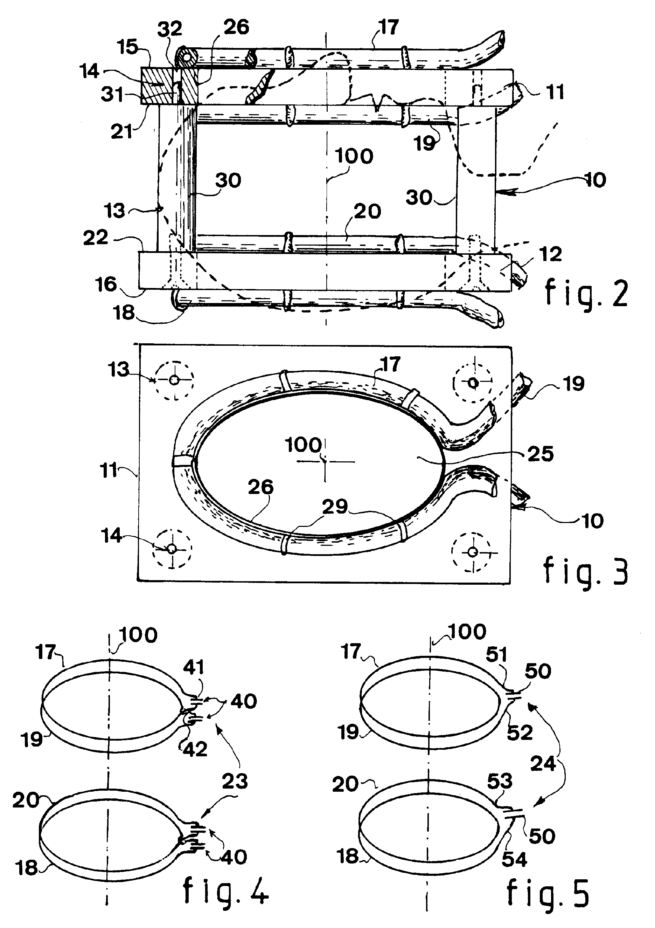

L'antenne 10 comprend en outre, soit des premiers moyens de couplage capacitifs 23 pour coupler les deux extrémités de chacune des spires 17 - 20, comme représenté sur la figure 4, soit des seconds moyens de couplage capacitifs 24, comme représenté sur la figure 5, d'une extrémité de la première spire 17 avec une extrémité de la troisième 19, et d'une extrémité de la deuxième 18 avec une extrémité de la quatrième 20, les autres extrémités étant reliées deux à deux pour former deux boucles de deux spires chacune.

Bien entendu, l'antenne comprend des moyens 29, comme des liens, entourant les conducteurs formant ces spires et dont les extrémités sont fixées sur les plaques, pour solidariser les spires respectivement sur les faces des deux plaques de façon que les boucles de courant soient centrées sensiblement sur un même axe 100 sensiblement perpendiculaire aux faces de ces plaques.

Une antenne telle que décrite ci-dessus est particulièrement adaptée pour effectuer une image du cerveau humain. Aussi, afin que les spires entourent au plus près cette partie du corps humain, au moins l'une des deux plaques, par exemple la plaque 11 destinée à entourer la partie supérieure du visage du patient, comporte une découpe 25, et les (ou la) spires 17, 19 associées à la plaque 11 sont alors sensiblement situées sur le bord 26 de cette découpe (figure 3). Dans ce cas d'utilisation du dispositif d'imagerie par résonance magnétique, la longueur des moyens d'entretoise 13 est inférieure à l'épaisseur de la tête du patient dont il est nécessaire de former une image, de façon que le bord 26 de la découpe 25 entoure la face du patient quand l'arrière de sa tête repose sur l'autre plaque 12. Pour permettre une encore meilleure position au plus près des spires, la seconde plaque 12 peut comporter, elle aussi, une découpe comme celle 25 réalisée dans la plaque 11 et les spires 18, 20 qui lui sont associées sont situées sur le bord de cette découpe.

Pour illustrer cet avantage il a été représenté, en traits interrompus sur la figure 2, une tête de patient entourée d'une antenne selon l'invention permettant de bien faire ressortir le fait que les spires hautes et basses entourent parfaitement au plus près le cerveau du patient à examiner.

Un tel positionnement de l'antenne par rapport à la partie du corps à analyser est facilement obtenu avec les moyens de fixation 14 enclipsables - déclipsables. Les moyens d'entretoise 13 étant constitués, par exemple, de plusieurs entretoise 30, par exemple quatre, les moyens de fixation 14 comportent un ergot mâle 31 solidaire, dans ce mode de réalisation, d'une extrémité des entretoises 30 et un orifice femelle complémentaire 32 réalisé dans l'autre élément, en l'occurrence la plaque 11, dans lequel est apte à être enfiché l'ergot 31.

La structure décrite ci-dessus permet d'adapter différentes boucles de courant hautes et basses et de disposer les deux plaques sur lesquelles elles sont situées à différentes distances l'une de l'autre, de façon à créer un champ magnétique secondaire perpendiculaire au champ principal et à mieux répondre aux besoins du rôle de l'antenne.

La figure 4 représente un premier mode de réalisation des moyens de couplage capacitifs. Selon ce premier mode de réalisation, les moyens de couplage 23 sont constitués par un condensateur électrique 40 dont les deux bornes 41, 42 sont respectivement reliées aux deux extrémités d'une spire, Ce mode de réalisation des moyens de couplage capacitifs impose donc l'utilisation d'un condensateur par spire, mais permet d'obtenir plusieurs combinaisons, par exemple deux boucles, une haute et une basse, ou quatre boucles, deux hautes et deux basses, montées en parallèle.

La figure 5 illustre, elle, un second mode de réalisation possible de ces moyens de couplage 24 constitués, dans ce cas, par deux condensateurs électriques 50 dont les bornes 51,52 - 53,54 sont respectivement connectées à une extrémité de chacune des deux première 17 et troisième 19 spires et à une extrémité de chacune des deux deuxième 18 et quatrième 20 spires, les autres extrémités de ces spires étant reliées électriquement deux à deux pour former deux boucles de deux spires chacune. Ces moyens de couplage 24 permettent d'obtenir une valeur de self plus importante que dans le mode selon la figure 4.

Dans le cas de l'application de l'antenne 10 au dispositif d'imagerie par résonance magnétique nucléaire du cerveau, les deux extrémités d'une spire sont recourbées vers l'extérieur de cette spire, de façon à aménager entre elles un espace pour le passage du cou du patient. Si l'antenne comporte deux paires de spires, les extrémités de ces spires sont alors agencées pour engendrer un champ magnétique secondaire homogène. Pour cela, les deux extrémités d'une spire située d'un côté d'une plaque sont sensiblement parallèles aux deux extrémités correspondantes de la spire située de l'autre côté de la même plaque, comme illustré sur la figure 2.

Par ailleurs, le mot "plaque" utilisé dans la description précédente doit être compris comme représentant tout support permettant de maintenir les première et troisième spires, d'une part, et les deuxième et quatrième, d'autre part, sensiblement dans deux plans à une distance l'un de l'autre déterminée.

## Revendications

1. Antenne (10) pour dispositif (1) d'imagerie par résonance magnétique nucléaire, caractérisée par le fait qu'elle comprend :
deux plaques de support (11,12) en matériau isolant électrique,
des moyens d'entretoise (13) pour maintenir les deux dites plaques à une distance déterminée l'une de l'autre dans deux plans sensiblement parallèles,
des moyens de fixation (14) enclipsables - déclipsables d'au moins une des deux dites plaques avec lesdits moyens d'entretoise,
au moins deux première (17) et deuxième (18) spires en matériau conducteur électrique,
des moyens (29) pour fixer lesdites spires respectivement sur une première face (15,16) des deux dites plaques pour former deux boucles de courant centrées sensiblement sur un même axe (100) sensiblement perpendiculaire auxdites faces desdites plaques, et
des moyens de couplage capacitifs (23,24) des extrémités de chaque boucle de courant.

2. Antenne selon la revendication 1, caractérisée par le fait qu'au moins l'une (11) des deux plaques comporte une découpe (25), ladite spire associée à ladite plaque étant sensiblement située sur le bord (26) de ladite découpe.

3. Antenne selon l'une des revendications 1 et 2, caractérisée par le fait qu'au moins deux troisième (19) et quatrième (20) spires sont respectivement fixées sur les deux faces (21,22) opposées auxdites premières faces (15,16) desdites plaques (11,12).

4. Antenne selon la revendication 1, caractérisée par le fait que lesdits moyens (23) de couplage capacitifs sont constitués par un premier condensateur électrique (40) dont les deux bornes (41,42) sont respectivement connectées aux deux extrémités d'une spire.

5. Antenne selon la revendication 3, caractérisée par le fait que les moyens de couplage (24) sont constitués par un deuxième condensateur électrique (50) reliant une extrémité de chacune des deux dites première (17) et troisième (19) spires et par un troisième condensateur électrique (50) reliant une extrémité de chacune des deux dites deuxième (19) et quatrième (20) spires, les autres extrémités desdites spires étant reliées électriquement deux à deux.

6. Antenne selon l'une des revendications 2 à 5, caractérisée par le fait que la longueur des moyens d'entretoise (13) est inférieure à l'épaisseur de la tête du patient dont il est nécessaire de former une image.

7. Antenne selon l'une des revendications 1 à 6, caractérisée par le fait que les moyens de fixation enclipsables - déclipsables (14) sont constitués par un ergot mâle (31) solidaire de l'un des deux élément, moyens d'entretoise et plaque, et par un orifice femelle complémentaire (32) réalisé dans l'autre élément, dans lequel est apte à être enfiché ledit ergot (31).

8. Antenne selon l'une des revendications 1 à 7, caractérisée par le fait que les extrémités des première (17) et deuxième (18) spires sont recourbées vers l'extérieur desdites spires.

9. Antenne selon les revendications 3 et 8, caractérisée par le fait que les extrémités des première (17) et troisième (19) spires sont parallèles, ainsi que les extrémités des deuxième (18) et quatrième (20) spires.

10. Antenne selon l'une des revendications précédentes, caractérisée par le fait que lesdites plaques sont en un matériau plastique.

## Patentansprüche

1. Antenne (10) für eine Vorrichtung (1) zur optischen Abbildung durch Kernspinresonanz,
dadurch gekennzeichnet, daß sie aus
zwei Trägerplatten (11, 12) aus elektrisch isolierendem Material,
Verstrebungsmitteln (13), um die beiden genannten Platten in zwei genau parallelen ebenen in einem bestimmten Abstand voneinander zu halten,
Befestigungsmitteln (14) zum Anklipsen / Abklipsen von wenigstens einer der beiden genannten Platten mit den genannten Verstrebungsmitteln,
wenigstens zwei Windungen aus elektrisch leitendem Material, einer ersten (17) und einer zweiten (18),
Mitteln (29) zur Befestigung der genannten Windungen an einer ersten Seite (15 bzw. 16) der beiden genannten Platten, um zwei Stromschleifen zu bilden, die genau auf ein und derselben Achse (100) zentriert sind, die genau senkrecht zu den genannten Seiten der genannten Platten ist, und
kapazitiven Kopplungsmitteln (23, 24) für die Enden jeder Stromschleife besteht.

2. Antenne nach Anspruch 1, dadurch gekennzeichnet, daß wenigstens die eine (11) der beiden Platten einen Ausschnitt (25) aufweist, wobei die genannte mit der genannten Platte verbundene Windung sich genau auf dem Rand (26) des genannten Ausschnitts befindet.

3. Antenne nach einem der Ansprüche 1 und 2, dadurch gekennzeichnet, daß wenigstens zwei Windungen, eine dritte (19) und eine vierte (20), an den beiden Seiten (21 bzw. 22) befestigt sind, die von den genannten ersten Seiten (15, 16) der genannten Platten (11, 12) abgewandt sind.

4. Antenne nach Anspruch 1, dadurch gekennzeichnet, daß die genannten kapazitiven Kopplungsmittel (23) von einem ersten elektrischen Kondensator (40) gebildet werden, dessen beide Klemmen (41, 42) jeweils mit einem der beiden Enden einer Windung verbunden sind.

5. Antenne nach Anspruch 3, dadurch gekennzeichnet, daß die Kopplungsmittel (24) von einem zweiten elektrischen Kondensator (50) gebildet werden, der jeweils mit einem Ende der beiden genannten ersten (17) und dritten (19) Windungen verbunden ist, und von einem dritten Kondensator (50), der jeweils mit einem Ende der beiden genannten zweiten (18) und vierten (20) Windungen verbunden ist, wobei die anderen Enden der genannten Windungen paarweise elektrisch verbunden sind.

6. Antenne nach einem der Ansprüche 2 bis 5, dadurch gekennzeichnet, daß die Länge der Verstrebungsmittel (13) geringer ist als die Dicke des Patientenkopfes, von dem eine Abbildung hergestellt werden soll.

7. Antenne nach einem der Ansprüche 1 bis 6, dadurch gekennzeichnet, daß die anklipsbaren / abklipsbaren Befestigungsmittel (14) von einem Zapfen (31), der mit einem der beiden Teile, Verstrebungsmitteln und Platte, fest verbunden ist, und von einer entsprechenden, in dem anderen Teil ausgebildeten Aufnahmeöffnung (32) gebildet werden, in die der genannte Zapfen (31) eingesteckt werden kann.

8. Antenne nach einem der Ansprüche 1 bis 7, dadurch gekennzeichnet, daß die Enden der ersten (17) und zweiten (18) Windung nach außerhalb der genannten Windungen gekrümmt sind.

9. Antenne nach den Ansprüchen 3 und 8, dadurch gekennzeichnet, daß die Enden der ersten (17) und dritten (19) Windung parallel sind, desgleichen die Enden der zweiten (18) und vierten (20) Windung.

10. Antenne nach einem der vorhergehenden Ansprüche, dadurch gekennzeichnet, daß die genannten Platten aus einem Kunststoffmaterial bestehen.

## Claims

1. Antenna (10) for nuclear magnetic resonance imagery device (1), characterised in that it comprises:
two support plates (11, 12) made of electrically insulating material,
bracing means (13) for holding the two said plates at a determined distance from each other in two substantially parallel planes,
fixing means (14) which can be clipped - unclipped for fixing at least one of the two'said plates with said bracing means,
at least two first (17) and second (18) turns made of electrically conductive material,
means (29) for fixing said turns respectively on a first face (15, 16) of the two said plates in order to form two current loops substantially centered on a same axis (100) which is substantially perpendicular to said faces of said plates, and
capacitive coupling means (23, 24) for coupling the ends of each current loop.

2. Antenna according to claim 1, characterised in that at least one (11) of the two plates has a cut-out (25), said turn associated with said plate being substantially located on the edge (26) of said cut-out.

3. Antenna according to one of the claims 1 and 2, characterised in that at least two third (19) and fourth (20) turns are respectively fixed on the two faces (21, 22) opposite said first faces (15, 16) of said plates (11, 12).

4. Antenna according to claim 1, characterised in that said capacitive coupling means (23) are formed by a first electrical capacitor (40), the two terminals (41, 42) of which are respectively connected to the two ends of one turn.

5. Antenna according to claim 3, characterised in that the coupling means (24) are formed by a second electrical capacitor (50) connecting one end of each of the two said first (17) and third (19) turns and by a third electrical capacitor (50) connecting one end of each of the two said second (19) (sic) and fourth (20) turns, the other ends of said turns being electrically connected in pairs.

6. Antenna according to one of the claims 2 to 5, characterised in that the length of the bracing means (13) is less than the thickness of the head of the patient of whom it is necessary to form an image.

7. Antenna according to one of the claims 1 to 6, characterised in that the fixing means (14) which can be clipped - unclipped are formed by a male pin (31) integral with one of the two elements, bracing means and plate, and by a complementary finale opening (32) realized in the other element, into which opening said pin (31) can be plugged.

8. Antenna according to one of the claims 1 to 7, characterised in that the ends of the first (17) and second (18) turns are curved towards the exterior of said turns.

9. Antenna according to claims 3 and 8, characterised in that the ends of the first (17) and third (19) turns are parallel, just as the ends of the second (18) and fourth (20) turns.

10. Antenna according to one of the previous claims, characterised in that said plates are made of a plastics material.
